Europäisches Patentamt

European Patent Office

Office européen des brevets

(19)

(11) **EP 0 848 414 A1**

(12) # DEMANDE DE BREVET EUROPEEN

(43) Date de publication:
**17.06.1998 Bulletin 1998/25**

(51) Int Cl.⁶: **H01L 21/20**, C30B 25/18

(21) Numéro de dépôt: **97402963.9**

(22) Date de dépôt: **08.12.1997**

(84) Etats contractants désignés:
**AT BE CH DE DK ES FI FR GB GR IE IT LI LU MC NL PT SE**
Etats d'extension désignés:
**AL LT LV MK RO SI**

(30) Priorité: **10.12.1996 FR 9615141**

(71) Demandeur: **FRANCE TELECOM**
**75015 Paris (FR)**

(72) Inventeurs:
• **Harmand, Jean-Christophe**
**94800 Villejuif (FR)**
• **Kohl, Andreas**
**75013 Paris (FR)**

(74) Mandataire: **Texier, Christian**
**Cabinet Regimbeau,**
**26, Avenue Kléber**
**75116 Paris (FR)**

(54) **Procédé de relaxation de film contraint par fusion de couche interfaciale**

(57) La présente invention, relative au domaine des technologies de fabrication de matériaux semi-conducteurs pour composants opto-électroniques et micro-électroniques, concerne un procédé de réalisation d'empilements de couches métamorphiques de matériaux ayant plusieurs pour cent de désaccord de maille entre eux ou par rapport au substrat comprenant:

a) Le dépôt pseudomorphique d'un materiau I sur un substrat à une température < Tf (température de fusion du substrat).
b) Le dépôt pseudomorphique d'un matériau E sur le materiau I à une température < Tf.
c) récuit de la couche interfaciale
d) Refroidissement de la couche interfaciale.
e) Epitaxie d'un matériau sur le substrat recouvert.

EP 0 848 414 A1

# Description

La présente invention, relative au domaine des technologies de fabrication de matériaux semi-conducteurs en couches minces pour composants opto-électroniques et micro-électroniques, concerne un procédé de réalisation d'empilements de couches métamorphiques de matériaux ayant plusieurs pour cent de désaccord de maille entre eux ou par rapport au substrat.

La possibilité de réaliser des empilements de couches minces de matériaux semi-conducteurs de nature, et donc de propriété différentes, est à l'origine de nombreux composants opto-électroniques et microélectroniques dont certains sont déjà produits de façon industrielle. Dans la plupart des cas, ces structures sont construites à partir de matériaux possédant des paramètres de maille égaux ou proches (différence relative de quelques millièmes). Cette restriction est liée à une limitation physique souvent décrite comme l'épaisseur critique d'un matériau E de paramètre $a_e$, épitaxié sur un matériau substrat S de paramètre $a_s$, et qui dépend du désaccord de maille relatif $(a_e-a_s)/a_s$ entre les deux matériaux et des conditions de mise en oeuvre.

Avant l'épaisseur critique, le matériau E croît de façon bidimensionnelle et contrainte : son paramètre de maille subit élastiquement une déformation tétragonale pour être égal à celui du substrat dans le plan des couches. La couche du matériau E est dite pseudomorphique. Les matériaux pseudomorphiques sont largement utilisés aujourd'hui.

Au-delà de l'épaisseur critique, on observe soit la génération de dislocations dans le plan de l'interface, soit la transformation de la couche bidimensionnelle en îlots de matière. Les deux phénomènes permettent la relaxation du matériau E.

Dans les deux cas, la poursuite de la croissance du matériau E va générer des dislocations. Ces dislocations vont traverser l'épaisseur du matériau E pour trouver une surface libre où finir. Le matériau E est donc dégradé. Quand le matériau E a retrouvé son paramètre de maille naturel, la couche est dite métamorphique. Pour obtenir des couches métamorphiques de bonne qualité, on trouve dans l'art antérieur deux sortes d'approches.

Une première approche consiste à utiliser des couches tampons intermédiaires qui permettent d'accumuler les défauts et de préserver les couches supérieures.

Ces tampons peuvent être par exemple des super-réseaux contraints (T.Won, S.Agarwala and H.Morkoç, Appl. Phys. Lett. 53 (1988) 2311), ou des couches graduelles en composition (G.H.Olsen, M.S.Abrahams, C. J.Buiocchi and T.J.Zamerowski, J.Appl. Phys. 46 (1975) 1643, et J.C.Harmand, T.Matsuno and K.Inoue, Jap. J. Appl. Phys. 28 (1989) L1101), ou encore des couches épitaxiées à très basse température (T.Ueda, S.Onozawa, M.Akiyama and M.Sakuta, J.Cryst. Growth 93 (1988) 517). Leur épaisseur est généralement supérieure au micron. Un cas largement étudié dans l'art antérieur est celui de l'épitaxie de GaAs sur Si.

L'utilisation de tampons épais présente l'inconvénient que le volume de ce tampon, dont le but est de collecter les défauts structuraux, ne doit pas avoir de rôle actif dans le fonctionnement du composant qui sera réalisé a posteriori. Ce volume mort limite grandement les possibilités qu'offre l'association de matériaux de paramètres de maille très différents puisqu'il ne permet pas une proximité suffisante des deux matériaux de part et d'autre du tampon.

Une autre approche plus récente consiste à réaliser un collage épitaxial entre les deux matériaux.

Chacune des couches à juxtaposer est alors pré-épitaxiée sur un substrat avec accord de maille. Les surfaces sont mises en contact en appliquant une pression, et la formation de liaisons atomiques est assurée par chauffage sous atmosphère contrôlée d'hydrogène ou d'azote. Des résultats intéressants sont obtenus par cette technique, les défauts de désaccord restant confinés près de l'interface de collage sans s'étendre dans le volume des matériaux (G.Patriarche, F.Jeannès, F. Glas, and J.L.Oudar, Proceedings of the 9th int. Conf. on Microscopy of Semiconducting Materials, Oxford, 1995). Cette technique se développe actuellement pour la réalisation de laser semi-conducteur à cavité verticale. Des couches actives accordées à InP sont par exemple rapportées sur des miroirs épitaxiés sur GaAs (D.I. Babic, K.Streubel, R.P.Mirin, N.M.Margalit, J.E.Bowers, E.L.Hu, D.E.Mars, L.Yang, K.Carey, Phys. Tech. Lett. (1995)). Des reports de GaAs sur Si (Y.H.Yo, R.Bhat, D. M.Hwang, C.Chua and C.H.Lin, Appl. Phys. Lett. 62 (1993) 1038) ou encore InP sur Si (K.Mori, K.Tokutome, K.Nishi and S.Sugou, Electron. Lett. 56 (1990) 737) ont aussi été réalisés.

Dans le cas du collage épitaxial, les démonstrations ont été faites jusqu'à présent sur des surfaces d'échantillons très limitées, de l'ordre de 1 cm$^2$. Rien ne garantit qu'un tel procédé reste efficace pour des surfaces supérieures. Par ailleurs, cette technique nécessite deux épitaxies distinctes sur leurs substrats respectifs, succédées par ledit collage, et le retrait sélectif d'un des substrats. Dès lors qu'on veut faire intervenir plusieurs collages, la méthode devient plutôt lourde. Enfin, la présence d'impuretés, telles que O, C et Si, en concentration élevée à l'interface de collage est probable, puisque les deux surfaces sont couvertes d'un oxyde natif avant le collage.

La présente invention a pour objet un procédé de réalisation d'empilements de couches métamorphiques, de matériaux semi-conducteurs de type III-V, II-VI ou IV, ayant plusieurs pour cent de désaccord de maille entre eux ou par rapport au substrat. Le procédé selon l'invention permet avantageusement de pallier les limitations des techniques connues dans l'art antérieur, comme l'utilisation de tampons épais ou le collage épitaxial, en mettant en oeuvre des empilements métamorphiques réalisés en une seule manipulation, indépendamment de la taille de l'échantillon, et sans dégradation de l'état du matériau, notamment sans dislocations traversant le volume. Le procédé selon l'invention permet de confiner les défauts structuraux dans une zone interfaciale extrêmement mince qui assure la proximité desdits matériaux.

Le procédé selon l'invention met en oeuvre un matériau E de température de fusion $TF^e$ à épitaxier sur un matériau substrat S de température de fusion $TF^s$ par l'intermédiaire d'une couche interfaciale, constituée d'un matériau I. La température de fusion $T_F$ du matériau I est suffisamment basse pour être compatible avec la non destruction des matériaux E et S. En particulier, les composés InSb, GaSb, CdTe et Ge, ayant respectivement des températures de fusion de 530, 712, 800 et 937°C peuvent être utilisés comme matériau de couche interfaciale.

La séquence d'étapes de croissance du procédé selon l'invention est la suivante :

a) dépôt pseudomorphique du matériau I de paramètre de maille $a_i$ sur le matériau substrat S de paramètre de maille $a_s$, à une température T inférieure à $T_F$. 1

Pour obtenir un dépôt pseudomorphique, l'épaisseur du matériau I doit être inférieure à l'épaisseur critique fonction du désaccord $(a_i-a_s)/a_s$ et de la température T à laquelle on réalise le dépôt.

La zone interfaciale constituée du matériau I est élaborée dans un équipement d'épitaxie, par exemple un équipement d'épitaxie par jets moléculaires (EJM), et contient une très faible concentration d'impuretés. Elle est aussi mince que possible, mais doit réaliser au moins un plan essentiellement constitué de liaisons atomiques spécifiques au matériau I la constituant. Elle comporte moins de dix, typiquement deux ou trois couches monoatomiques.

T peut être abaissée comparativement à la température habituelle de croissance pour que l'épaisseur critique soit plus élevée si besoin est.

b) dépôt pseudomorphique du matériau E de paramètre de maille $a_e$ sur le matériau I constituant la couche interfaciale, à une température T inférieure à $T_F$.

La condition d'obtention d'une couche pseudomorphique est que l'épaisseur de E soit inférieure à l'épaisseur critique fonction de $(a_e-a_s)/a_s$ et que de plus l'épaisseur totale des deux dépôts soit inférieure à l'épaisseur critique fonction des désaccords $(a_i-a_s)/a_s$ et $(a_e-a_s)/a_s$ qui peuvent s'ajouter ou se compenser suivant leurs signes.

Comme lors du premier dépôt, T peut être abaissée comparativement à la température habituelle de croissance pour que l'épaisseur critique soit plus élevée si besoin est.

Cette deuxième couche peut être de l'ordre de quelques couches monoatomiques, typiquement moins de 10.

La séquence des étapes a) et b) peut être avantageusement répétée, typiquement de 1 à 10 fois, afin d'obtenir un empilement périodique des couches I et E qui permettra une meilleure encapsulation du matériau S prévenant sa dégradation pendant le recuit.

c) recuit de la couche interfaciale à une température suffisante pour forcer la relaxation de la couche du matériau E par génération de dislocations localisées dans I.

Les liaisons au sein de la couche interfaciale s'affaiblissent. On découple ainsi les matériaux E et S, et la contrainte appliquée sur le film E par le substrat S disparaît. Le film E se relaxe. Le désaccord de maille est accommodé par des déplacements d'atomes de la couche interfaciale. La température de mise en oeuvre de cette étape peut être égale à $T_F$, auquel cas on réalise la fusion de la couche interfaciale.

On préférera un recuit rapide (inférieur à une minute) pour éviter la mise à l'équilibre de l'empilement qui risque de provoquer des échanges atomiques entre les différentes couches, ainsi que des changements de morphologie.

d) refroidissement de la couche interfaciale.

Pendant sa resolidification, le matériau I de la couche interfaciale conserve tous les défauts structuraux qui permettent d'accommoder la différence de paramètre de maille entre les matériaux E et S,

e) épitaxie du matériau E.

Le matériau E ou tout autre matériau de même paramètre de maille $a_e$ peut dès lors être épitaxié avec une épaisseur quelconque, supérieure à l'épaisseur critique, sans création de nouveau défaut.

Cette séquence d'étape peut être répétée un nombre indéfini de fois afin d'obtenir l'empilement de couches de matériaux souhaité, le matériau E d'une première séquence d'étapes jouant le rôle du matériau S dans une deuxième séquence d'étapes, etc.

Selon un mode préféré de réalisation de l'invention, on peut choisir une combinaison de matériaux S, I, E telle que

$$a_s < a_i \qquad (1)$$

et

$$a_e < a_i \qquad (2)$$

ce qui conduit généralement à une température de fusion $T_F$ du matériau I de la couche interfaciale inférieure à celle des deux matériaux E et S.

Le matériau I peut être choisi parmi InSb, GaSb, CdTe et Ge.

On peut choisir en particulier une combinaison de matériaux S, I, E telle que

$$a_s < a_e < a_i \qquad (3)$$

ou de préférence telle que

$$a_e < a_s < a_i \qquad (4)$$

afin de faciliter le dépôt pseudomorphique des deux matériaux I et E en couches ultraminces sur le matériau substrat S.

Sur la base de la condition (4), on peut choisir par exemple les combinaisons (S, I, E) = (GaSb, InSb, InP), (GaSb, InSb, GaAs), (InAs, InSb, GaAs), (InP, GaSb, AlAs), (Si, Ge, III-AsN).

La présente invention concerne également tout matériau obtenu par le procédé précédemment décrit entrant dans l'élaboration de dispositifs opto-électroniques et micro-électroniques, par exemple un laser à microcavité verticale.

L'exemple qui suit illustre l'invention sans en limiter la portée.

Exemple :

On se propose de réaliser l'empilement S/I/E : InP/ GaSb/AlAs. Dans ce cas,

- Le dépôt du matériau de couche interfaciale GaSb est réalisé à une vitesse de croissance de 0,1 à 1 monocouche par seconde et à une température de 300°C à 400°C. L'épaisseur du dépôt peut être de trois monocouches soit environ 1 nm.
- Le dépôt du matériau à épitaxier AlAs est réalisé à une vitesse de croissance de 1 monocouche par seconde et à une température de 300°C à 400°C. L'épaisseur du dépôt de AlAs est de l'ordre de 5 nm.
- Etape de fusion : On monte en quelques secondes à une température de 712°C (voir un peu en dessous). Le refroidissement s'effectue aussi en quelques secondes.
- La poursuite de la croissance du matériau AlAs est réalisée à 680°C.

**Revendications**

1. Procédé de réalisation d'empilements de couches métamorphiques de matériaux semi-conducteurs de type III-V, II-VI ou IV ayant plusieurs pour cent de désaccord de maille entre eux ou par rapport au substrat, caractérisé en ce qu'il met en oeuvre un matériau E de température de fusion $T_F{}^e$, à épitaxier sur un matériau substrat S, de température de fusion $T_F{}^e$, par l'intermédiaire d'une couche interfaciale constituée d'un matériau I, de température de fusion $T_F$ compatible avec la non destruction des matériaux E et S, et caractérisé en ce qu'il comprend la séquence d'étapes suivante :

a) dépôt pseudomorphique du matériau I sur le matériau substrat S à une température inférieure à $T_F$,
b) dépôt pseudomorphique du matériau E sur le matériau I constituant la couche interfaciale à une température inférieure à $T_F$,
c) recuit de la couche interfaciale à une température suffisante pour forcer la relaxation de la couche du matériau E par génération de dislocations localisées dans I,
d) refroidissement de la couche interfaciale,
e) épitaxie du matériau E ou de tout autre matériau de même paramètre de maille $a_e$.

2. Procédé selon la revendication 1, caractérisé en ce que le dépôt du matériau I de l'étape a) comporte moins de dix couches monoatomiques, typiquement deux ou trois.

3. Procédé selon la revendication 1 ou 2, caractérisé en ce que le dépôt du matériau E de l'étape b) comporte quelques couches monoatomiques, typiquement quelques dizaines.

4. Procédé selon l'une des revendications 1 à 3, caractérisé en ce que les températures de mise en oeuvre des étapes a) et b) peuvent être abaissées comparativement à la température habituelle de croissance pour que l'épaisseur critique soit plus élevée si besoin est.

5. Procédé selon l'une des revendications 1 à 4, caractérisé en ce que le dépôt du matériau I est réalisé dans un équipement d'épitaxie, par exemple un équipement d'épitaxie par jets moléculaires.

6. Procédé selon l'une des revendications 1 à 5, caractérisé en ce que le matériau S de paramètre $a_s$, le matériau I de paramètre $a_i$ et le matériau E de paramètre $a_e$ sont choisis tels que

$$a_s < a_i \qquad (1)$$

et

$$a_e < a_i \qquad (2)$$

ce qui permet généralement de vérifier les conditions $T_F < T_F{}^s$ et $T_F < T_F{}^e$.

7. Procédé selon l'une des revendications 1 à 6, caractérisé en ce que le matériau I est choisi parmi InSb, GaSb, CdTe et Ge.

8. Procédé selon l'une quelconque des revendications précédentes, caractérisé en ce que

$$a_s < a_e < a_i \qquad (3)$$

9. Procédé selon l'une des revendications 1 à 7, caractérisé en ce que

$$a_e < a_s < a_i \qquad (4)$$

10. Procédé selon la revendication 9, caractérisé en ce que l'on choisit les combinaisons de matériaux (S, I,E) parmi (GaSb, InSb, InP), (GaSb, InSb, GaAs), (InAs, InSb, GaAs), (InP, GaSb, AlAs) et (Si, Ge, III-AsN).

11. Procédé selon l'une des revendications 1 à 10, caractérisé en ce que la séquence des étapes a) et b) est répétée une à dix fois.

12. Procédé selon l'une des revendications 1 à 11, caractérisé en ce que la séquence des étapes a) à e) est répétée un nombre indéfini de fois.

13. Procédé selon l'une des revendications 1 à 12, caractérisé en ce que la température de mise en oeuvre de l'étape c) est égale à $T_F$.

14. Matériau obtenu par le procédé selon l'une des revendications 1 à 13 entrant dans l'élaboration de dispositifs opto-électroniques et micro-électroniques, par exemple un laser à microcavité verticale.

EP 0 848 414 A1

| Office européen des brevets | RAPPORT DE RECHERCHE EUROPEENNE | Numéro de la demande EP 97 40 2963 |

## DOCUMENTS CONSIDERES COMME PERTINENTS

| Catégorie | Citation du document avec indication, en cas de besoin, des parties pertinentes | Revendication concernee | CLASSEMENT DE LA DEMANDE (Int.Cl.6) |
|---|---|---|---|
| A | EP 0 450 228 A (MITSUBISHI ELECTRIC CORP) 9 octobre 1991 * page 3, ligne 10 - page 7, ligne 49 * | 1 | H01L21/20 C30B25/18 |
| A | KADOIWA K ET AL: "STUDY OF INITIAL BUFFER LAYER IN GAAS-ON-SI GROWTH" JOURNAL OF CRYSTAL GROWTH, vol. 115, no. 1 / 04, 2 décembre 1991, pages 128-132, XP000322683 * page 129, colonne 1, alinéa 2 - page 130, colonne 1, alinéa 2 * | 1 | |
| A | US 5 225 368 A (DODSON BRIAN W) 6 juillet 1993 * revendication 1 * | 1 | |
| A | US 4 963 949 A (WANLASS MARK W ET AL) 16 octobre 1990 | | |

DOMAINES TECHNIQUES RECHERCHES (Int.Cl.6)

H01L
C30B

Le présent rapport a été établi pour toutes les revendications

| Lieu de la recherche | Date d'achèvement de la recherche | Examinateur |
|---|---|---|
| LA HAYE | 16 mars 1998 | Schuermans, N |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant